# EUROPEAN PATENT SPECIFICATION

(11) **EP 4 395 079 B1**
(45) Date of publication and mention of the grant of the patent: **16.04.2025**
(21) Application number: 23211457.9
(22) Date of filing: 22.11.2023
(51) Int. Cl.: H01R 12/59, H01R 12/77

(54) **CONNECTOR AND CONNECTING METHOD**
VERBINDER UND VERBINDUNGSVERFAHREN
CONNECTEUR ET PROCÉDÉ DE CONNEXION

(30) Priority: 28.12.2022 JP 2022211261
(43) Date of publication of application: 03.07.2024
(73) Proprietor: Japan Aviation Electronics Industry, Ltd., Tokyo 150-0043 (JP)
(72) Inventor: HASHIGUCHI, Osamu, Tokyo, 150-0043 (JP)
(74) Representative: Qip Patentanwälte Dr. Kuehn & Partner mbB

(56) References cited:
- JP-A- 2018 129 244
- US-A1- 2021 104 824

## Description

### BACKGROUND OF THE INVENTION

The present invention relates to a connector and a connecting method, particularly to a connector connected to a sheet type connection object having a flexible conductor exposed on at least one surface of the connection object.

In recent years, attention has been drawn to so-called smart clothes that can obtain user's biological data such as the heart rate and the body temperature only by being worn by the user. Such smart clothes have an electrode disposed at a measurement site, and when a wearable device serving as a measurement device is electrically connected to the electrode, biological data can be transmitted to the wearable device.

The electrode and the wearable device can be interconnected by, for instance, use of a connector connected to a flexible conductor drawn from the electrode.

As a connector of this type, for example, JP 2018-129244 A discloses a connector as illustrated in FIG. 33. The connector includes a housing 2 and a base member 3 that are disposed on the opposite sides of a flexible substrate 1 to sandwich the flexible substrate 1 therebetween. Tubular portions 4A of contacts 4 are passed through contact through-holes 2A of the housing 2, and flanges 4B of the contacts 4 are sandwiched between the housing 2 and flexible conductors 1A exposed on the top surface of the flexible substrate 1.

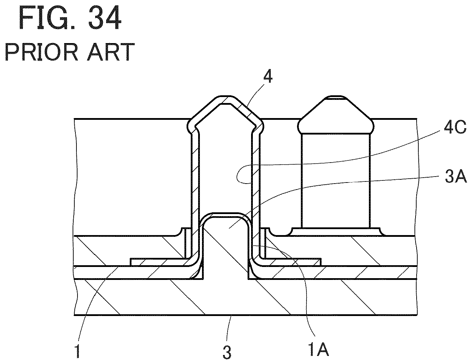

In this state, when the base member 3 is pushed toward the housing 2, as shown in FIG. 34, a projection 3A of the base member 3 is inserted into a projection accommodating portion 4C of the contact 4 with the flexible substrate 1 being sandwiched therebetween, and the inner surface of the projection accommodating portion 4C makes contact with the flexible conductor 1A with a predetermined contact force, whereby the contact 4 is electrically connected to the flexible conductor 1A.

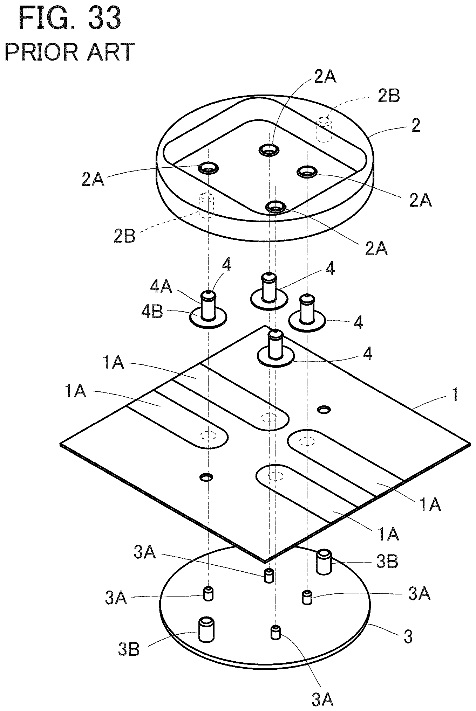

Further, housing fixing posts 3B formed to project from the base member 3 are press-fitted into post accommodating portions 2B of the housing 2 as shown in FIG. 33, so that the housing 2 and the base member 3 are fixed to each other.

When fitted to the connector disclosed in JP 2018-129244 A, a wearable device can be connected to electrodes constituted of the flexible conductors.

However, when a flexible conductor 1B is exposed on the bottom surface of the flexible substrate 1, the connector of JP 2018-129244 A would be useless in electrically connecting the flexible conductor 1B to the contact 4.

From US 2021/204 824 A1 a connector is known including a pushing member having a projection, a support member disposed to contact a lateral surface of the projection, and a contact made of a conductive material and having a support member facing portion facing the support member, a part of the flexible conductor being disposed between the support member and the support member facing portion of the contact, the lateral surface of the projection pressing the part of the flexible conductor against the support member facing portion of the contact via the support member, whereby the contact is electrically connected to the flexible conductor.

### SUMMARY OF THE INVENTION

The present invention has been made to solve the foregoing problem and aims at providing a connector that can electrically connecting a contact to a flexible conductor of a connection object regardless of whether the flexible conductor is exposed on the top surface or the bottom surface of the connection object.

A connector according to the present invention comprises:
a plug contact having a conductive property and including a recessed portion extending along a fitting axis;
an inner contact having a conductive property and inserted in the recessed portion; and
a bottom insulator including a projection extending along the fitting axis and inserted in the recessed portion,
wherein the inner contact includes
   a contact portion that is elastically displaceable in a direction perpendicular to the fitting axis and makes contact with the plug contact in the recessed portion,
   a projection contacting portion that is elastically displaceable in a direction perpendicular to the fitting axis and makes contact with a lateral surface of the projection in the recessed portion, and
   a pressing portion that is elastically displaceable in a direction perpendicular to the fitting axis and faces an inner surface of the recessed portion, and
a part of a connection object of sheet type having a flexible conductor exposed on at least one surface of the connection object is sandwiched between the pressing portion and the inner surface of the recessed portion in a direction perpendicular to the fitting axis, the inner surface of the recessed portion makes contact with a top surface of the connection object, and the pressing portion makes contact with a bottom surface of the connection object, whereby the plug contact is electrically connected to the flexible conductor directly when the flexible conductor is exposed on the top surface of the connection object, and the plug contact is electrically connected to the flexible conductor via the inner contact when the flexible conductor is exposed on the bottom surface of the connection object.

A connecting method according to the present invention is a method for connecting the plug contact to the flexible conductor of the connection object by use of the connector according to claim 1, the method comprising:
disposing the connection object with respect to the plug contact such that the flexible conductor exposed on at least one surface of the connection object is positioned at an opening end portion of the recessed portion of the plug contact;
inserting the inner contact into the recessed portion while pushing the connection object into the recessed portion such that the contact portion of the inner contact makes contact with the plug contact within the recessed portion and that the connection object is sandwiched between the pressing portion of the inner contact and the inner surface of the recessed portion in a direction perpendicular to the fitting axis; and
inserting the projection of the bottom insulator into the recessed portion such that the lateral surface of the projection makes contact with the projection contacting portion of the inner contact, whereupon the inner surface of the recessed portion makes contact with the top surface of the connection object, and the pressing portion makes contact with the bottom surface of the connection object, whereby the plug contact is electrically connected to the flexible conductor directly when the flexible conductor is exposed on the top surface of the connection object, and the plug contact is electrically connected to the flexible conductor via the inner contact when the flexible conductor is exposed on the bottom surface of the connection object.

### BRIEF DESCRIPTION OF THE DRAWINGS

FIG. 1 is a perspective view showing a connector according to Embodiment 1.
FIG. 2 is an assembly view of the connector according to Embodiment 1.
FIG. 3 is a perspective view showing a top insulator used in the connector of Embodiment 1.
FIG. 4 is a perspective view showing a plug contact used in the connector of Embodiment 1.
FIG. 5 is a cross-sectional view showing the plug contact used in the connector of Embodiment 1.
FIG. 6 is a perspective view showing a bottom insulator used in the connector of Embodiment 1.
FIG. 7 is a perspective view showing a projection of the bottom insulator used in the connector of Embodiment 1.
FIG. 8 is a side view of the projection of the bottom insulator used in the connector of Embodiment 1, as viewed from a first direction.
FIG. 9 is a side view of the projection of the bottom insulator used in the connector of Embodiment 1, as viewed from a second direction.
FIG. 10 is a cross-sectional side view of the projection of the bottom insulator used in the connector of Embodiment 1, as viewed from the second direction.
FIG. 11 is a perspective view of a connection object to be connected to the connector of Embodiment 1, as viewed from an obliquely upper position.
FIG. 12 is a perspective view of the connection object to be connected to the connector of Embodiment 1, as viewed from an obliquely lower position.
FIG. 13 is a perspective view showing a reinforcement sheet used in the connector of Embodiment 1.
FIG. 14 is a perspective view showing an inner contact used in the connector of Embodiment 1.
FIG. 15 is a side view of the inner contact used in the connector of Embodiment 1, as viewed from the second direction.
FIG. 16 is a side view of the inner contact used in the connector of Embodiment 1, as viewed from the first direction.
FIG. 17 is a perspective view showing the inner contact retained on the projection of the bottom insulator in Embodiment 1.
FIG. 18 is a partial cross-sectional side view showing the state of the interior of the plug contact in the connector of Embodiment 1 during the assembling operation, as viewed from the second direction.
FIG. 19 is a partial cross-sectional side view showing the state of the interior of the plug contact in the connector of Embodiment 1 connected to the connection object, as viewed from the second direction.
FIG. 20 is a partial cross-sectional side view showing the state of the interior of the plug contact in the connector of Embodiment 1 connected to the connection object, as viewed from the first direction.
FIG. 21 is an assembly view of a connector according to Embodiment 2.
FIG. 22 is a perspective view showing a bottom insulator used in the connector of Embodiment 2.
FIG. 23 is a perspective view showing a projection of the bottom insulator used in the connector of Embodiment 2.
FIG. 24 is a perspective view showing an inner contact used in the connector of Embodiment 2.
FIG. 25 is a side view of the inner contact used in the connector of Embodiment 2, as viewed from the second direction.
FIG. 26 is a partial cross-sectional side view showing the state of the interior of the plug contact in the connector of Embodiment 2 during the assembling operation, as viewed from the second direction.
FIG. 27 is a partial cross-sectional side view showing the state of the interior of the plug contact in the connector of Embodiment 2 connected to the connection object, as viewed from the second direction.
FIG. 28 is a perspective view showing a connector according to Embodiment 3.
FIG. 29 is a perspective view showing a plug contact used in the connector of Embodiment 3.
FIG. 30 is a side view showing the plug contact used in the connector of Embodiment 3.
FIG. 31 is a partial cross-sectional side view showing the state of the interior of the plug contact in the connector of Embodiment 3 during the assembling operation, as viewed from the second direction.
FIG. 32 is a partial cross-sectional side view showing the state of the interior of the plug contact in the connector of Embodiment 3 connected to the connection object, as viewed from the second direction.
FIG. 33 is an exploded perspective view of a conventional connector.
FIG. 34 is a partial cross-sectional view showing the conventional connector.

### DETAILED DESCRIPTION OF THE INVENTION

Embodiments of the present invention are described below based on the accompanying drawings.

### Embodiment 1

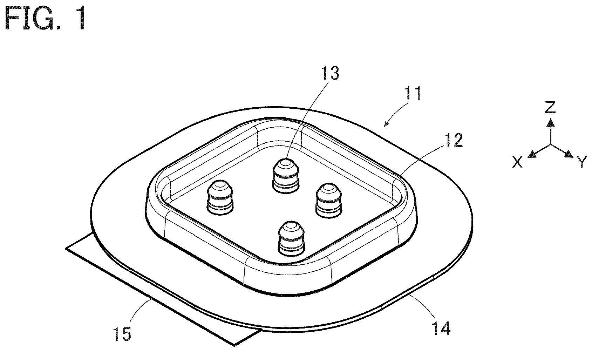

FIG. 1 shows a connector 11 according to Embodiment 1. The connector 11 is used as, for instance, a garment-side connector for fitting a wearable device and includes a housing 12 made of an insulating material. Four plug contacts 13 are retained in the housing 12, and a reinforcement sheet 14 and a sheet type conductive member 15 being superposed on each other are retained by the housing 12. The sheet type conductive member 15 constitutes a connection object to which the connector 11 is connected.

The four plug contacts 13 are aligned in two rows parallel to each other and disposed to project perpendicularly to the sheet type conductive member 15.

For convenience, the reinforcement sheet 14 and the sheet type conductive member 15 are defined as extending in an XY plane, the alignment direction of the four plug contacts 13 is referred to as "Y direction," and the direction in which the four plug contacts 13 project is referred to as "+Z direction." The Z direction is a fitting direction in which the connector 11 is fitted to a counter connector.

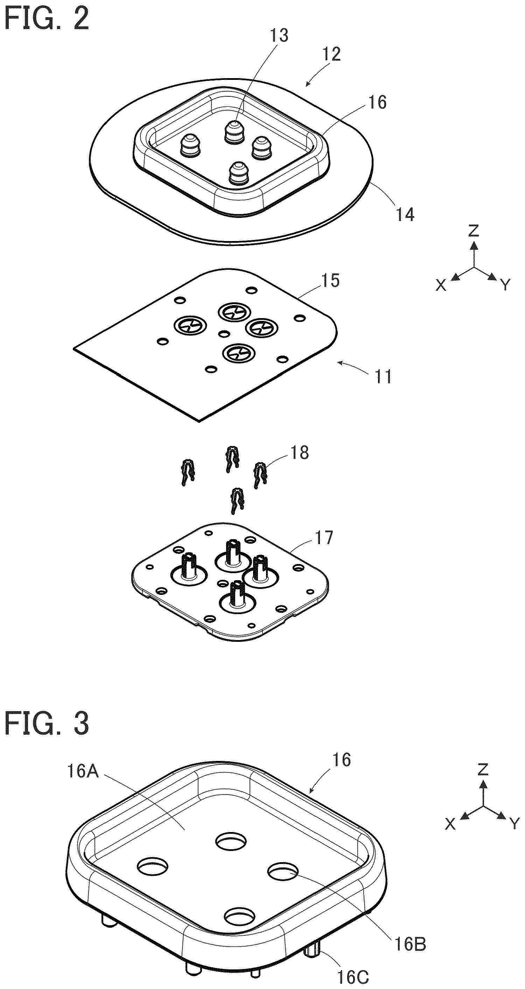

FIG. 2 shows an assembly view of the connector 11. The connector 11 includes a top insulator 16 and a bottom insulator 17, and these top and bottom insulators 16 and 17 constitute the housing 12.

The four plug contacts 13 are retained in the top insulator 16. The reinforcement sheet 14 is disposed on the bottom surface of the top insulator 16 on the -Z direction side, and the sheet type conductive member 15 is disposed on the -Z direction side of the reinforcement sheet 14. Further, four inner contacts 18 are disposed on the -Z direction side of the sheet type conductive member 15, and the bottom insulator 17 is disposed on the -Z direction side of the inner contacts 18. The four inner contacts 18 separately correspond to the four plug contacts 13.

As shown in FIG. 3, the top insulator 16 includes a recessed portion 16A opening in the +Z direction and four contact through-holes 16B formed within the recessed portion 16A. The recessed portion 16A constitutes a counter connector accommodating portion in which a part of a counter connector (not shown) is to be accommodated, and the four contact through-holes 16B correspond to the four plug contacts 13. A plurality of bosses 16C projecting in the -Z direction are formed on a surface, facing the -Z direction, of the top insulator 16.

The four plug contacts 13 are made of a conductive material such as metal and are to be connected to corresponding contacts of a counter connector (not shown) when a part of the counter connector is accommodated in the recessed portion 16A of the top insulator 16.

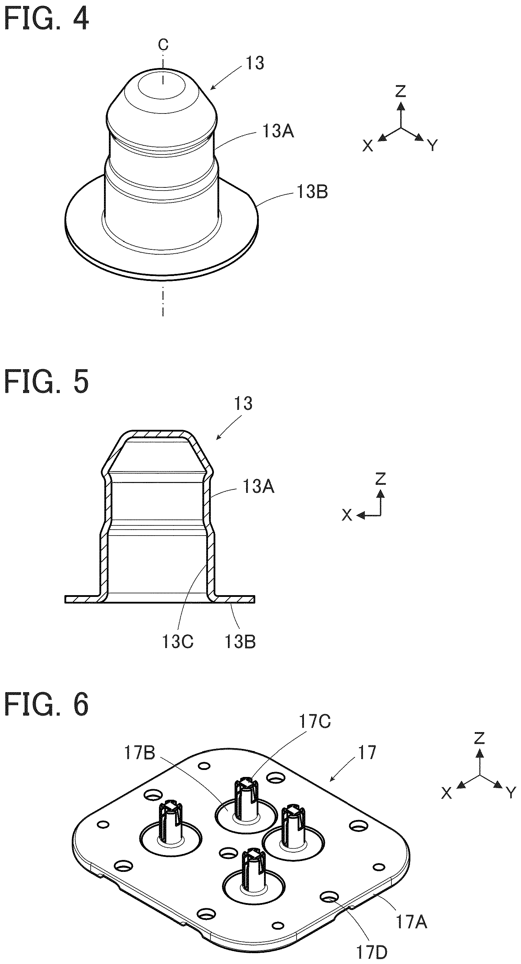

As shown in FIG. 4, the plug contact 13 includes a protrusion portion protruding in the +Z direction along a fitting axis C, specifically, a tubular portion 13A in the shape of a cylindrical tube, and a flange 13B in a discoid shape extending in a radial direction along an XY plane from the -Z directional base end of the tubular portion 13A.

As shown in FIG. 5, the interior of the tubular portion 13A forms a recessed portion 13C opening in the -Z direction.

The fitting axis C is an axis passing through the center of the tubular portion 13A and extending in the direction in which the connector 11 and a counter connector are fitted to each other.

While the tubular portion 13A has the shape of a cylindrical tube, the cross section thereof is not limited to a circle and may be any of various shapes such as an ellipse and a polygon as long as the tubular portion 13A has the recessed portion 13C in its interior.

The four plug contacts 13 can be each used as a terminal for transmitting electric signals.

As shown in FIG. 6, the bottom insulator 17 includes a flat plate portion 17A, and the flat plate portion 17A is provided with four circular recessed portions 17B opening in the +Z direction. The four recessed portions 17B correspond to the four plug contacts 13. The four recessed portions 17B are provided separately with four projections 17C projecting in the +Z direction from central parts of the respective recessed portions 17B.

Further, the flat plate portion 17A is provided with a plurality of through-holes 17D corresponding to the bosses 16C of the top insulator 16.

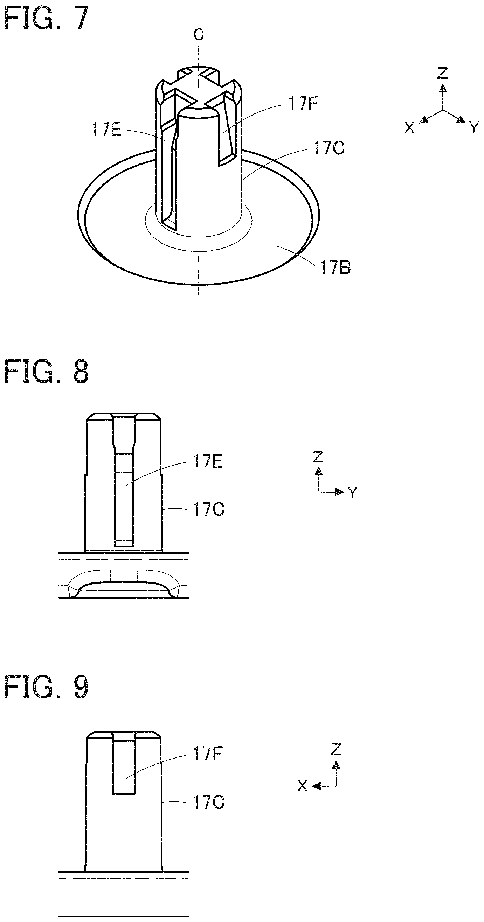

As shown in FIG. 7, the projection 17C formed in the recessed portion 17B of the bottom insulator 17 has the shape of a circular column extending in the Z direction along the fitting axis C of the plug contact 13 situated to correspond to the recessed portion 17B. First arm insertion grooves 17E extending in the Z direction are formed at the lateral surface of the projection 17C separately on the opposite sides in the X direction, and second arm insertion grooves 17F extending in the Z direction are formed at the lateral surface of the projection 17C separately on the opposite sides in the Y direction.

In other words, of the lateral surface of the projection 17C of circular columnar shape, a part facing the +X direction and a part facing the -X direction are each provided with the first arm insertion groove 17E, and a part facing the +Y direction and a part facing the -Y direction are each provided with the second arm insertion groove 17F.

As shown in FIG. 8, the first arm insertion groove 17E extends over the entire Z directional height of the projection 17C from the +Z directional end of the projection 17C to the -Z directional end thereof, and as shown in FIG. 9, the second arm insertion groove 17F extends from the +Z directional end of the projection 17C to an intermediate portion thereof in the Z direction.

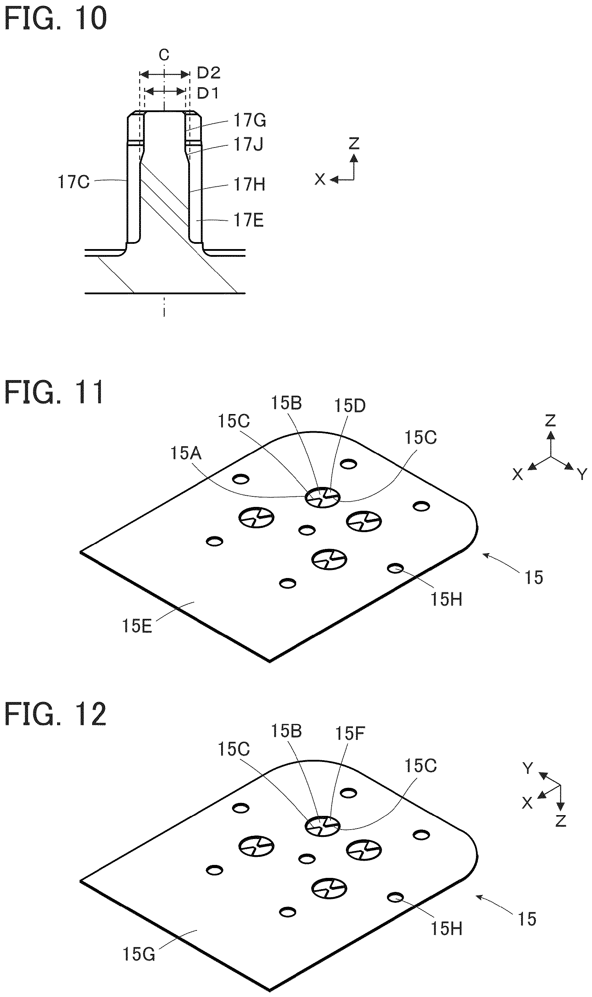

As shown in FIG. 10, each first arm insertion groove 17E includes: a first bottom surface 17G extending along a YZ plane in a portion on the +Z direction side; a second bottom surface 17H extending along a YZ plane in a portion on the -Z direction side and situated away from the fitting axis C in the X direction compared to the first bottom surface 17G; and an inclined bottom surface 17J connecting the first bottom surface 17G and the second bottom surface 17H and inclined with respect to the fitting axis C.

In an XZ plane passing the pair of first arm insertion grooves 17E, the projection 17C has a thickness D1 in the X direction at a Z directional position where the first bottom surface 17G is formed and, at a Z directional position where the second bottom surface 17H is formed, a thickness D2 in the X direction that is larger than the thickness D1 at the Z directional position of the first bottom surface 17G.

The sheet type conductive member 15 has a multilayer structure in which a plurality of wiring layers each formed of a flexible conductor and a plurality of insulating layers are laminated.

As shown in FIG. 11, four contact arrangement regions 15A used to arrange the four plug contacts 13 are defined on the top surface, facing the +Z direction, of the sheet type conductive member 15. Each of the four contact arrangement regions 15A is provided with an opening 15B penetrating the sheet type conductive member 15 and further with a pair of substantially triangular protruding portions 15C protruding inward within the opening 15B separately from the +X directional edge and the -X directional edge of the contact arrangement region 15A. A wiring layer 15D is exposed on the protruding portions 15C protruding inward within the four openings 15B, while an insulating layer 15E is exposed in the other region than the four openings 15B.

On the bottom surface, facing the -Z direction, of the sheet type conductive member 15, a wiring layer 15F is exposed on the protruding portions 15C protruding inward within the four openings 15B, while an insulating layer 15G is exposed in the other region than the four openings 15B.

Further, the sheet type conductive member 15 is provided in its peripheral portion with a plurality of through-holes 15H corresponding to the bosses 16C of the top insulator 16 as shown in FIGS. 11 and 12.

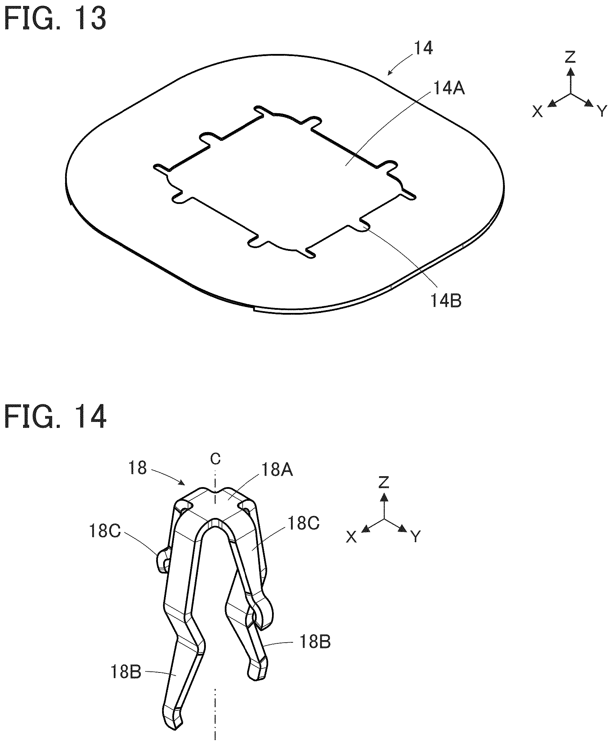

As shown in FIG. 13, the reinforcement sheet 14 is used to reinforce a mounting object (not shown) such as a garment on which the connector 11 is to be mounted. The reinforcement sheet 14 is made of an insulating material and provided at its center with an opening 14A. Further, a plurality of notches 14B corresponding to the bosses 16C of the top insulator 16 are formed along the periphery of the opening 14A of the reinforcement sheet 14.

FIG. 14 shows the structure of an inner contact 18. The inner contact 18 is formed of a plate member made of a conductive material such as metal and bent, and includes a base portion 18A situated on the fitting axis C and extending in an XY plane, a pair of first arm portions 18B extending in at least the -Z direction separately from the +X directional end and the -X directional end of the base portion 18A, and a pair of second arm portions 18C extending in at least the -Z direction separately from the +Y directional end and the -Y directional end of the base portion 18A. It should be noted that the X direction forms a first direction perpendicular to the fitting axis C and the Y direction forms a second direction perpendicular to the fitting axis C and also perpendicular to the first direction.

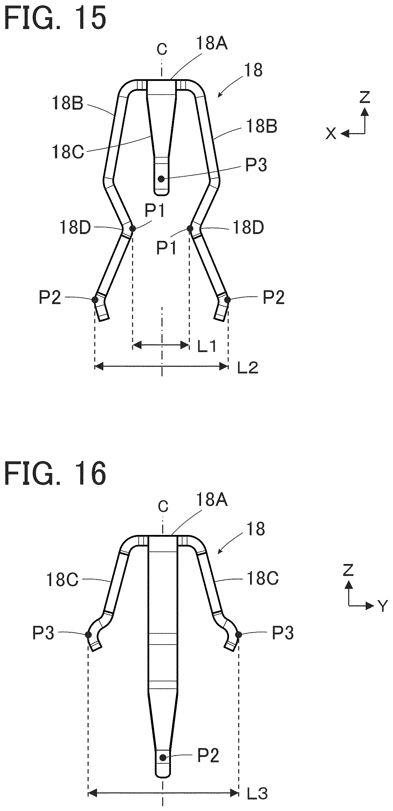

As shown in FIG. 15, the pair of first arm portions 18B face each other in the X direction and have a symmetrical shape with respect to a YZ plane passing the fitting axis C.

The pair of first arm portions 18B have, in their intermediate portions in the Z direction, a pair of first bending portions 18D bent to approach each other and each form a projecting shape, and projecting surfaces of the pair of first bending portions 18D that face each other form a pair of projection contacting portions P1 that are elastically displaceable in the X direction perpendicular to the fitting axis C.

The pair of first arm portions 18B also have, in their -Z directional tip portions, a pair of projecting surfaces facing the opposite directions from each other in the X direction, and this pair of projecting surfaces form a pair of pressing portions P2 that are elastically displaceable in the X direction perpendicular to the fitting axis C.

With no external force acting on the inner contact 18, a distance L1 between the pair of projection contacting portions P1 in the X direction has a dimension substantially equal to the thickness D1 of the projection 17C of the bottom insulator 17 shown in FIG. 10 and smaller than the thickness D2 thereof, and a distance L2 between the pair of pressing portions P2 in the X direction has a dimension substantially equal to or slightly smaller than a value obtained by subtracting a double of the thickness of the sheet type conductive member 15 from the inner diameter of the recessed portion 13C of the plug contact 13.

As shown in FIG. 16, the pair of second arm portions 18C slantingly extend from the +Y and -Y directional ends of the base portion 18A such that a gap therebetween in the Y direction gradually widens toward the -Z direction, face each other in the Y direction, and have a symmetrical shape with respect to an XZ plane passing the fitting axis C.

The -Z directional tip portions of the pair of second arm portions 18C have a pair of projecting surfaces facing the opposite directions from each other in the Y direction, and this pair of projecting surfaces form a pair of contact portions P3 that are elastically displaceable in the Y direction perpendicular to the fitting axis C.

With no external force acting on the inner contact 18, a distance L3 between the pair of contact portions P3 in the Y direction has a dimension larger than the inner diameter of the recessed portion 13C of the plug contact 13.

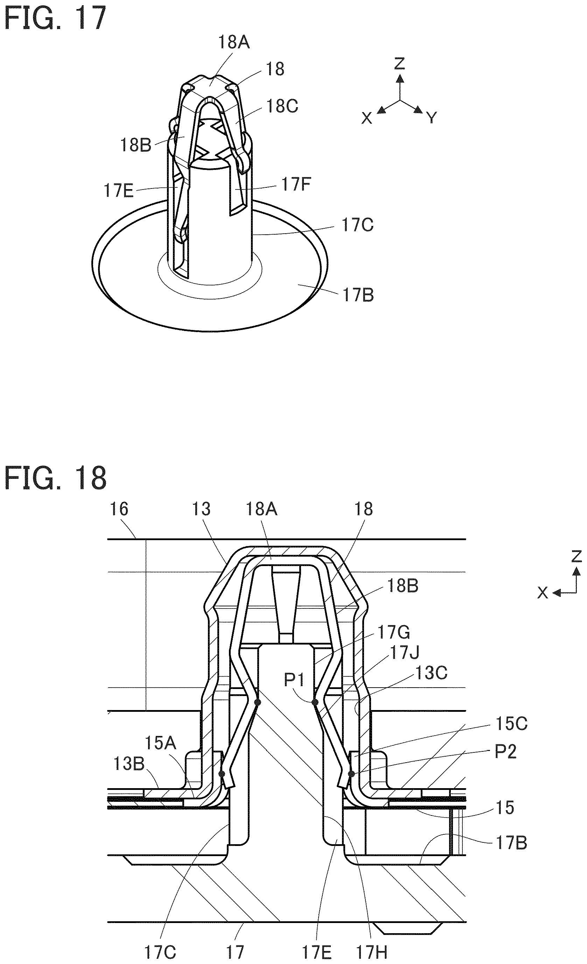

When the connector 11 is assembled, first, each inner contact 18 is temporarily retained on the corresponding projection 17C of the bottom insulator 17 as shown in FIG. 17. The inner contact 18 is temporarily retained on the projection 17C with the pair of first arm portions 18B being inserted in the pair of first arm insertion grooves 17E of the projection 17C and the pair of projection contacting portions P1 being in contact with the first bottom surfaces 17G of the first arm insertion grooves 17E shown in FIG. 10.

In the state where the inner contact 18 is temporarily retained on the projection 17C, the pair of second arm portions 18C of the inner contact 18 are not yet inserted in the pair of second arm insertion grooves 17F of the projection 17C.

Next, the bosses 16C of the top insulator 16 are inserted into the notches 14B of the reinforcement sheet 14. At this time, the four contact through-holes 16B of the top insulator 16 are situated inside the opening 14A of the reinforcement sheet 14.

Further, the tubular portions 13A of the plug contacts 13 are correspondingly inserted into the four contact through-holes 16B of the top insulator 16 from the -Z direction, and the sheet type conductive member 15 is disposed on the -Z direction side of the four plug contacts 13 such that each opening 15B and each pair of protruding portions 15C of the sheet type conductive member 15 are positioned at an opening end portion of the recessed portion 13C of the corresponding tubular portion 13A.

In this state, the bottom insulator 17 is pushed toward the top insulator 16 in the +Z direction with the sheet type conductive member 15 being sandwiched therebetween. At this time, as shown in FIG. 18, the flange 13B of each plug contact 13 is situated above the corresponding contact arrangement region 15A of the sheet type conductive member 15, and each inner contact 18 temporarily retained on the bottom insulator 17 is inserted into the recessed portion 13C of the corresponding plug contact 13 while pushing the corresponding pair of protruding portions 15C of the sheet type conductive member 15.

Consequently, the pair of protruding portions 15C of the sheet type conductive member 15 pushed into the recessed portion 13C of the plug contact 13 are sandwiched between the pair of pressing portions P2 formed at the -Z directional end portions of the pair of first arm portions 18B of the inner contact 18 and the inner surface of the recessed portion 13C of the plug contact 13.

Meanwhile, with no external force acting on the inner contact 18, the pair of pressing portions P2 have the distance L2 in the X direction that is substantially equal to or slightly smaller than a value obtained by subtracting a double of the thickness of the sheet type conductive member 15 from the inner diameter of the recessed portion 13C of the plug contact 13 as shown in FIG. 15; therefore, the pair of protruding portions 15C of the sheet type conductive member 15 are smoothly inserted into the recessed portion 13C of the plug contact 13 without being subjected to a large force from the inner contact 18 and being rubbed.

The pair of projection contacting portions P1 of the inner contact 18 are in contact with the first bottom surfaces 17G of the pair of first arm insertion grooves 17E of the projection 17C, and when the bottom insulator 17 is pushed toward the top insulator 16 in the +Z direction, the base portion 18A of the inner contact 18 makes contact with the bottom surface of the recessed portion 13C of the plug contact 13, the bottom surface being situated at the +Z directional end of the recessed portion 13C.

Further, when the bottom insulator 17 is pushed toward the top insulator 16, the pair of projection contacting portions P1 of the inner contact 18 are relatively moved in the -Z direction with respect to the projection 17C from the first bottom surfaces 17G of the pair of first arm insertion grooves 17E to the second bottom surfaces 17H thereof through the inclined bottom surfaces 17J thereof while being elastically displaced in the X direction.

Furthermore, when the bottom insulator 17 is pushed toward the top insulator 16, the bosses 16C of the top insulator 16 sequentially pass through the notches 14B of the reinforcement sheet 14, the through-holes 15H of the sheet type conductive member 15, and the through-holes 17D of the bottom insulator 17. Then, the ends of the bosses 16C projecting on the -Z direction side of the bottom insulator 17 are thermally deformed, whereby the top insulator 16 and the bottom insulator 17 are fixed to each other. Thus, the assembling operation of the connector 11 is completed.

Note that the plug contacts 13 are fixed to the top insulator 16 and the bottom insulator 17 because their flanges 13B are sandwiched between the top insulator 16 and the bottom insulator 17.

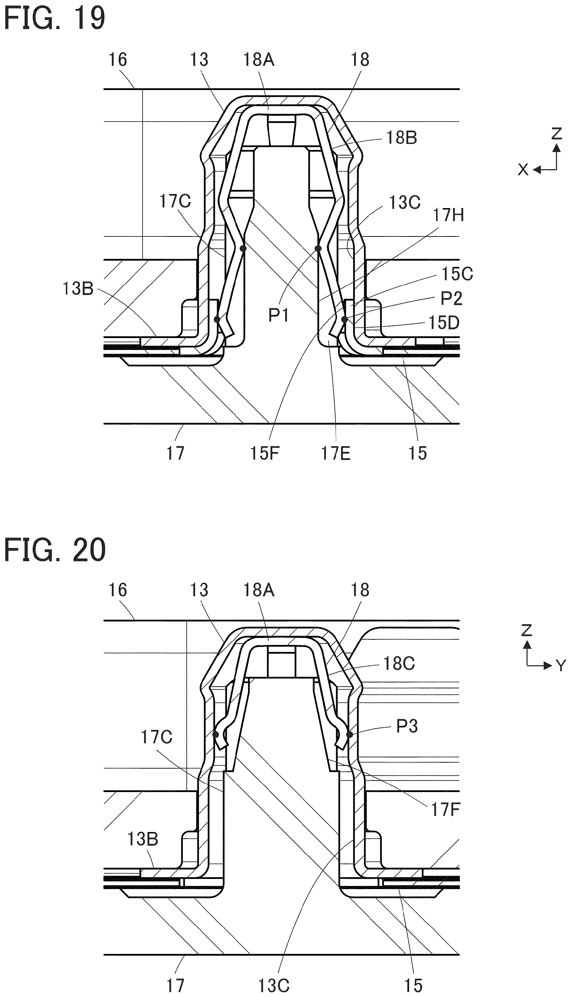

In the connector 11 thus assembled, the pair of projection contacting portions P1 of the inner contact 18 make contact with the second bottom surfaces 17H of the pair of first arm insertion grooves 17E of the projection 17C as shown in FIG. 19, so that the distance between the pair of projection contacting portions P1 in the X direction is widened, and accordingly, elastic forces acting to widen the distance between the pair of pressing portions P2 in the X direction are exerted on the pair of pressing portions P2. Consequently, the pair of protruding portions 15C of the sheet type conductive member 15 sandwiched between the pair of pressing portions P2 of the inner contact 18 and the inner surface of the recessed portion 13C of the plug contact 13 are separately pressed against the inner surface of the recessed portion 13C of the plug contact 13.

Meanwhile, inside each opening 15B of the sheet type conductive member 15, the wiring layer 15D is exposed on the top surfaces, facing the +Z direction, of the pair of protruding portions 15C, and the wiring layer 15F is exposed on the bottom surfaces thereof facing the -Z direction, as shown in FIGS. 11 and 12.

Accordingly, the wiring layer 15D on the top surfaces of the protruding portions 15C make contact with the inner surface of the recessed portion 13C of the plug contact 13 at a predetermined contact pressure, while the wiring layer 15F on the bottom surfaces of the protruding portions 15C make contact with the pressing portions P2 of the inner contact 18 at a predetermined contact pressure.

Further, as shown in FIG. 20, the pair of contact portions P3 formed at the tip portions of the pair of second arm portions 18B of the inner contact 18 inserted in the recessed portion 13C of the plug contact 13 are pressed against the inner surface of the recessed portion 13C of the plug contact 13, whereby the inner contact 18 is electrically connected to the plug contact 13.

Consequently, the wiring layer 15D exposed on the top surfaces of the protruding portions 15C of the sheet type conductive member 15 are electrically connected to the plug contact 13 directly, while the wiring layer 15F exposed on the bottom surfaces of the protruding portions 15C of the sheet type conductive member 15 are electrically connected to the plug contact 13 via the inner contact 18. In other words, both the wiring layers 15D and 15F are connected to the plug contact 13.

Thus, with the connector 11, both the wiring layer 15D formed of a flexible conductor disposed on the top surface side of the sheet type conductive member 15 and the wiring layer 15F formed of a flexible conductor disposed on the bottom surface side of the same can be electrically connected to one plug contact 13 owing to the use of the inner contact 18.

Therefore, when the connector 11 is connected to a sheet type conductive member having a flexible conductor exposed only on the top surface side, the plug contact 13 can be electrically connected to the flexible conductor on the top surface side of the sheet type conductive member, and when the connector 11 is connected to a sheet type conductive member having a flexible conductor exposed only on the bottom surface side, the plug contact 13 can be electrically connected to the flexible conductor on the bottom surface side of the sheet type conductive member.

Further, when the connector 11 is connected to a sheet type conductive member having flexible conductors exposed on both the top and bottom surface sides like the sheet type conductive member 15 in Embodiment 1, the plug contact 13 can be electrically connected to both the flexible conductor on the top surface side of the sheet type conductive member and the flexible conductor on the bottom surface side thereof. For instance, in the case of using, as the connection object, a sheet type conductive member having a multilayer structure in which flexible conductors each constituting a shielding layer are exposed on both the top and bottom surface sides separately and another flexible conductor constituting a signal wiring layer is disposed between those shielding layers while being insulated from both of the shielding layers, when the plug contact 13 connected to the shielding layers on the top and bottom surface sides is connected to a ground potential, a shielding effect with respect to the signal wiring layer is demonstrated, and highly accurate signal transmission can be carried out with the influence of disturbance caused by electromagnetic waves and other factors being minimized.

The pair of protruding portions 15C of the sheet type conductive member 15 are not subjected to a large force from the inner contact 18 and not rubbed when inserted into the recessed portion 13C of the plug contact 13, and hence, the flexible conductors forming the wiring layers 15D and 15F of the sheet type conductive member 15 are prevented from being broken, thus ensuring the reliability of electric connection between the flexible conductors and the plug contact 13.

While the reinforcement sheet 14 is disposed between the bottom insulator 17 and the top insulator 16 in the connector 11 of Embodiment 1, the reinforcement sheet 14 may be omitted when it is not necessary to reinforce the mounting object such as a garment on which the connector 11 is to be mounted.

### Embodiment 2

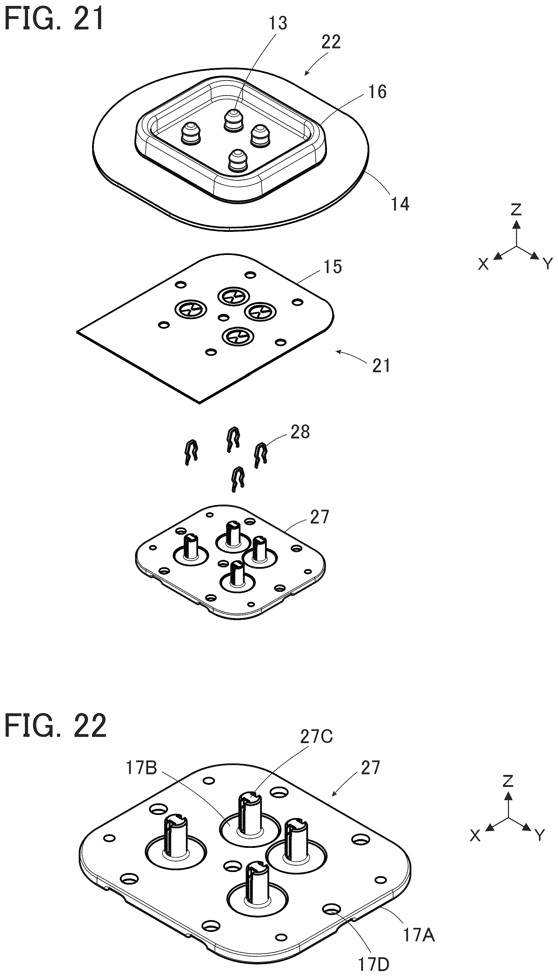

FIG. 21 shows an assembly view of a connector 21 according to Embodiment 2. The connector 21 is configured by, in the connector 11 of Embodiment 1, using a bottom insulator 27 in place of the bottom insulator 17 so that the top insulator 16 and the bottom insulator 27 constitute a housing 22 and also using four inner contacts 28 in place of the four inner contacts 18. The configuration other than the above is the same as that of the connector 11 of Embodiment 1.

Specifically, the four plug contacts 13 are retained in the top insulator 16, the reinforcement sheet 14 is disposed on the bottom surface of the top insulator 16 on the - Z direction side, and the sheet type conductive member 15 is disposed on the -Z direction side of the reinforcement sheet 14. Further, the four inner contacts 28 are disposed on the -Z direction side of the sheet type conductive member 15, and the bottom insulator 27 is disposed on the -Z direction side of the inner contacts 28.

As shown in FIG. 22, the bottom insulator 27 is configured such that four projections 27C are used in place of the four projections 17C in the bottom insulator 17 used in the connector 11 of Embodiment 1.

Specifically, the bottom insulator 27 includes the flat plate portion 17A, the flat plate portion 17A is provided with the four circular recessed portions 17B opening in the +Z direction, and the four projections 27C are formed to project in the +Z direction from central parts of the respective recessed portions 17B.

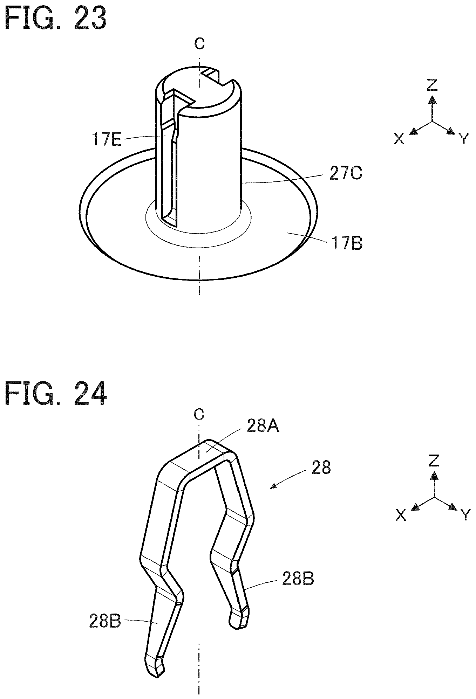

As shown in FIG. 23, the projection 27C of the bottom insulator 27 has the shape of a circular column extending in the Z direction along the fitting axis C of the plug contact 13 situated to correspond to the recessed portion 17B. The first arm insertion grooves 17E extending in the Z direction are formed at the lateral surface of the projection 27C separately on the opposite sides in the X direction. Those first arm insertion grooves 17E are the same as the first arm insertion grooves 17E of the projection 17C in Embodiment 1. No grooves are formed at the lateral surface of the projection 27C on the opposite sides in the Y direction.

FIG. 24 shows the structure of the inner contact 28. The inner contact 28 is formed of a plate member made of a conductive material such as metal and bent, and includes a base portion 28A situated on the fitting axis C and extending in an XY plane, and a pair of first arm portions 28B extending in the -Z direction separately from the +X directional end and the -X directional end of the base portion 28A.

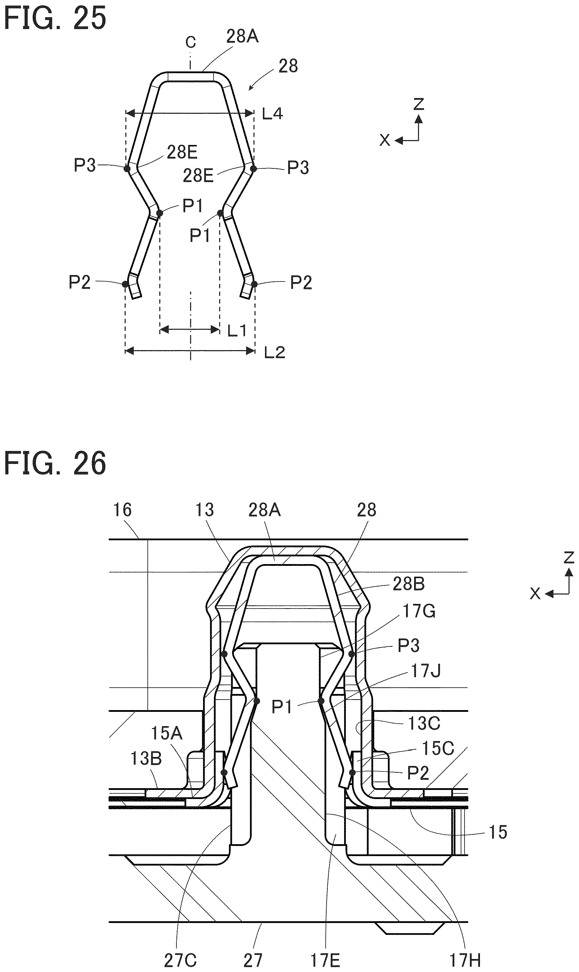

As shown in FIG. 25, the pair of first arm portions 28B face each other in the X direction and have a symmetrical shape with respect to a YZ plane passing the fitting axis C.

The pair of first arm portions 28B have a pair of projection contacting portions P1 that are formed in the intermediate portions in the Z direction and are elastically displaceable in the X direction and a pair of pressing portions P2 that are formed in the - Z directional tip portions and are elastically displaceable in the X direction, as with the pair of first arm portions 18B of the inner contact 18 in Embodiment 1.

The pair of first arm portions 28B further have a pair of second bending portions 28E bent to project in the opposite directions from each other along the X direction, each second bending portion 28E being situated between a joint portion at which the first arm portion 28B and the base portion 28A are joined together and the projection contacting portion P1. Projecting surfaces of the pair of second bending portions 28E that face the opposite directions from each other form a pair of contact portions P3 elastically displaceable in the X direction perpendicular to the fitting axis C.

With no external force acting on the inner contact 28, a distance L4 between the pair of contact portions P3 in the X direction has a dimension substantially equal to or slightly smaller than the inner diameter of the recessed portion 13C of the plug contact 13.

When the connector 21 is assembled, first, each inner contact 28 is temporarily retained on the corresponding projection 27C of the bottom insulator 27. The inner contact 28 is temporarily retained on the projection 27C with the pair of first arm portions 28B being inserted in the pair of first arm insertion grooves 17E of the projection 27C.

Next, the bosses 16C of the top insulator 16 are inserted into the notches 14B of the reinforcement sheet 14. Further, the tubular portions 13A of the plug contacts 13 are correspondingly inserted into the four contact through-holes 16B of the top insulator 16 from the -Z direction, and the sheet type conductive member 15 is disposed on the -Z direction side of the four plug contacts 13 such that each opening 15B and each pair of protruding portions 15C of the sheet type conductive member 15 are positioned at an opening end portion of the recessed portion 13C of the corresponding tubular portion 13A.

In this state, the bottom insulator 27 is pushed toward the top insulator 16 in the +Z direction with the sheet type conductive member 15 being sandwiched therebetween. At this time, as shown in FIG. 26, the flange 13B of each plug contact 13 is situated above the corresponding contact arrangement region 15A of the sheet type conductive member 15, and each inner contact 28 temporarily retained on the bottom insulator 27 is inserted into the recessed portion 13C of the corresponding plug contact 13 while pushing the corresponding pair of protruding portions 15C of the sheet type conductive member 15.

Consequently, the pair of protruding portions 15C of the sheet type conductive member 15 pushed into the recessed portion 13C of the plug contact 13 are sandwiched between the pair of pressing portions P2 formed at the -Z directional end portions of the pair of first arm portions 28B of the inner contact 28 and the inner surface of the recessed portion 13C of the plug contact 13.

However, with no external force acting on the inner contact 28, the pair of pressing portions P2 have a distance therebetween in the X direction that is substantially equal to or slightly smaller than a value obtained by subtracting a double of the thickness of the sheet type conductive member 15 from the inner diameter of the recessed portion 13C of the plug contact 13 as with Embodiment 1; therefore, the pair of protruding portions 15C of the sheet type conductive member 15 are smoothly inserted into the recessed portion 13C of the plug contact 13 without being subjected to a large force from the inner contact 28 and being rubbed.

The pair of projection contacting portions P1 of the inner contact 28 are in contact with the first bottom surfaces 17G of the pair of first arm insertion grooves 17E of the projection 27C, and when the bottom insulator 27 is pushed toward the top insulator 16 in the +Z direction, the base portion 28A of the inner contact 28 makes contact with the bottom surface, situated at the +Z directional end, of the recessed portion 13C of the plug contact 13.

Further, when the bottom insulator 27 is pushed toward the top insulator 16, the pair of projection contacting portions P1 of the inner contact 28 are relatively moved in the -Z direction with respect to the projection 27C from the first bottom surfaces 17G of the pair of first arm insertion grooves 17E to the second bottom surfaces 17H thereof through the inclined bottom surfaces 17J thereof while being elastically displaced in the X direction.

Furthermore, when the bottom insulator 27 is pushed toward the top insulator 16, the bosses 16C of the top insulator 16 sequentially pass through the notches 14B of the reinforcement sheet 14, the through-holes 15H of the sheet type conductive member 15, and the through-holes 17D of the bottom insulator 27. Then, the ends of the bosses 16C projecting on the -Z direction side of the bottom insulator 27 are thermally deformed, whereby the top insulator 16 and the bottom insulator 27 are fixed to each other. Thus, the assembling operation of the connector 11 is completed.

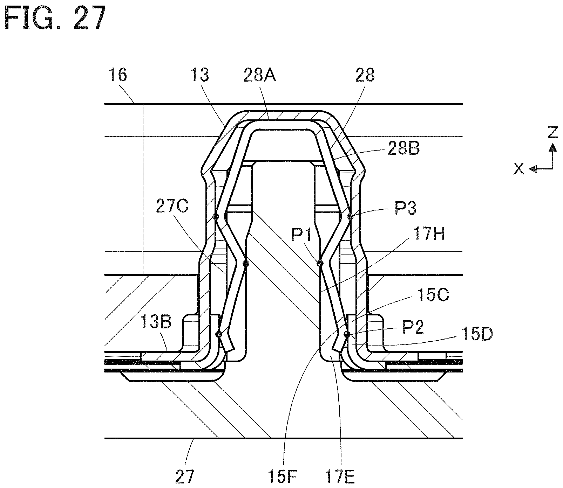

In the connector 21 thus assembled, the pair of projection contacting portions P1 of the inner contact 28 make contact with the second bottom surfaces 17H of the pair of first arm insertion grooves 17E of the projection 27C as shown in FIG. 27, so that the distance between the pair of projection contacting portions P1 in the X direction is widened, and accordingly, elastic forces act on the pair of pressing portions P2 to widen the distance between the pair of pressing portions P2 in the X direction. Consequently, the pair of protruding portions 15C of the sheet type conductive member 15 sandwiched between the pair of pressing portions P2 of the inner contact 28 and the inner surface of the recessed portion 13C of the plug contact 13 are separately pressed against the inner surface of the recessed portion 13C of the plug contact 13.

Accordingly, the wiring layer 15D on the top surfaces of the protruding portions 15C makes contact with the inner surface of the recessed portion 13C of the plug contact 13 at a predetermined contact pressure, while the wiring layer 15F on the bottom surfaces of the protruding portions 15C makes contact with the pressing portions P2 of the inner contact 28 at a predetermined contact pressure.

In addition, as the distance between the pair of projection contacting portions P1 of the inner contact 28 in the X direction is widened, elastic forces acting to widen the distance between the pair of contact portions P3 of the pair of first arm portions 28B in the X direction are exerted on the pair of contact portions P3, each contact portion P3 being formed between the joint portion at which the first arm portion 28B and the base portion 28A are joined together and the projection contacting portion P1. Thus, the pair of contact portions P3 are pressed against the inner surface of the recessed portion 13C of the plug contact 13, whereby the inner contact 28 is electrically connected to the plug contact 13.

Consequently, the wiring layer 15D exposed on the top surfaces of the protruding portions 15C of the sheet type conductive member 15 are electrically connected to the plug contact 13 directly, while the wiring layer 15F exposed on the bottom surfaces of the protruding portions 15C of the sheet type conductive member 15 are electrically connected to the plug contact 13 via the inner contact 28. In other words, both the wiring layers 15D and 15F are connected to the plug contact 13.

Thus, also in the connector 21, both the wiring layer 15D formed of a flexible conductor disposed on the top surface side of the sheet type conductive member 15 and the wiring layer 15F formed of a flexible conductor disposed on the bottom surface side of the same can be electrically connected to one plug contact 13 owing to the use of the inner contact 28.

Therefore, when the connector 21 is connected to a sheet type conductive member having a flexible conductor exposed only on the top surface side, the plug contact 13 can be electrically connected to the flexible conductor on the top surface side of the sheet type conductive member, and when the connector 21 is connected to a sheet type conductive member having a flexible conductor exposed only on the bottom surface side, the plug contact 13 can be electrically connected to the flexible conductor on the bottom surface side of the sheet type conductive member, as with Embodiment 1.

The pair of protruding portions 15C of the sheet type conductive member 15 are not subjected to a large force from the inner contact 28 and not rubbed when inserted into the recessed portion 13C of the plug contact 13, and hence, the flexible conductors forming the wiring layers 15D and 15F of the sheet type conductive member 15 are prevented from being broken, thus ensuring the reliability of electric connection between the flexible conductors and the plug contact 13.

### Embodiment 3

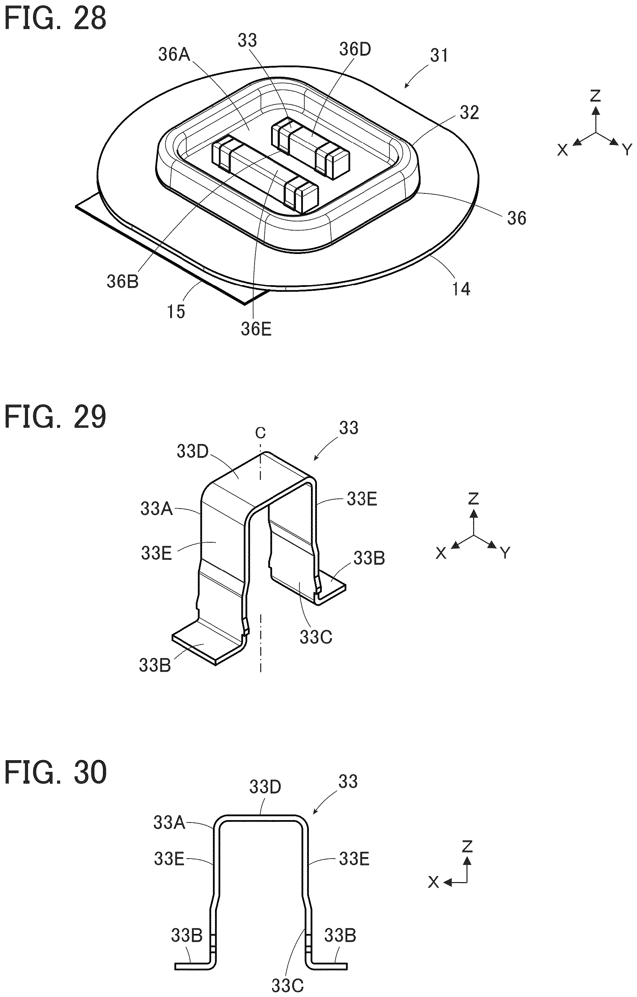

FIG. 28 shows a connector 31 according to Embodiment 3. The connector 31 is configured by, in the connector 21 of Embodiment 2, using a top insulator 36 in place of the top insulator 16 so that the top insulator 36 and the bottom insulator 27 constitute a housing 32 and also using four plug contacts 33 in place of the four plug contacts 13. The configuration other than the above is the same as that of the connector 21 of Embodiment 2.

The four plug contacts 33 are retained in the top insulator 36. The top insulator 36 includes a recessed portion 36A opening in the +Z direction as with the top insulator 16 shown in FIG. 3. Two jutting portions 36D and 36E jutting in the +Z direction are formed within the recessed portion 36A. The jutting portions 36D and 36E are situated at a distance in the X direction and each extend in the Y direction. Each of the jutting portions 36D and 36E is provided with two contact through-holes 36B penetrating the top insulator 36 in the Z direction, and the corresponding plug contacts 33 are exposed toward the +Z direction through the contact through-holes 36B.

It should be noted that the bosses 16C projecting in the -Z direction are formed on a surface, facing the -Z direction, of the top insulator 36, as with the top insulator 16 shown in FIG. 3.

The structure of the plug contact 33 is shown in FIGS. 29 and 30. The plug contact 33 is formed from a bent metal plate and includes a protrusion portion formed of a U-shaped portion 33A protruding in the +Z direction along the fitting axis C. The U-shaped portion 33A is composed of a top plate portion 33D extending along an XY plane and a pair of lateral plate portions 33E extending in the -Z direction along a YZ plane separately from the +X directional end and the -X directional end of the top plate portion 33D. The plug contact 33 further includes a pair of flanges 33B of flat plate shape extending in the opposite directions from each other along an XY plane separately from the -Z directional ends of the pair of lateral plate portions 33E.

The interior of the U-shaped portion 33A forms a recessed portion 33C.

Even with the use of the top insulator 36 and the four plug contacts 33 as above, the connector 31 can be assembled in the same manner as in Embodiment 2.

Specifically, the inner contacts 28 as shown in FIGS. 24 and 25 are temporarily retained on the corresponding projections 27C of the bottom insulator 27, the U-shaped portions 33A of the plug contacts 33 are correspondingly inserted into the four contact through-holes 36B of the top insulator 36 from the -Z direction, and the sheet type conductive member 15 is disposed on the -Z direction side of the four plug contacts 33 such that each opening 15B and each pair of protruding portions 15C of the sheet type conductive member 15 are positioned at an opening end portion of the recessed portion 33C of the corresponding U-shaped portion 33A.

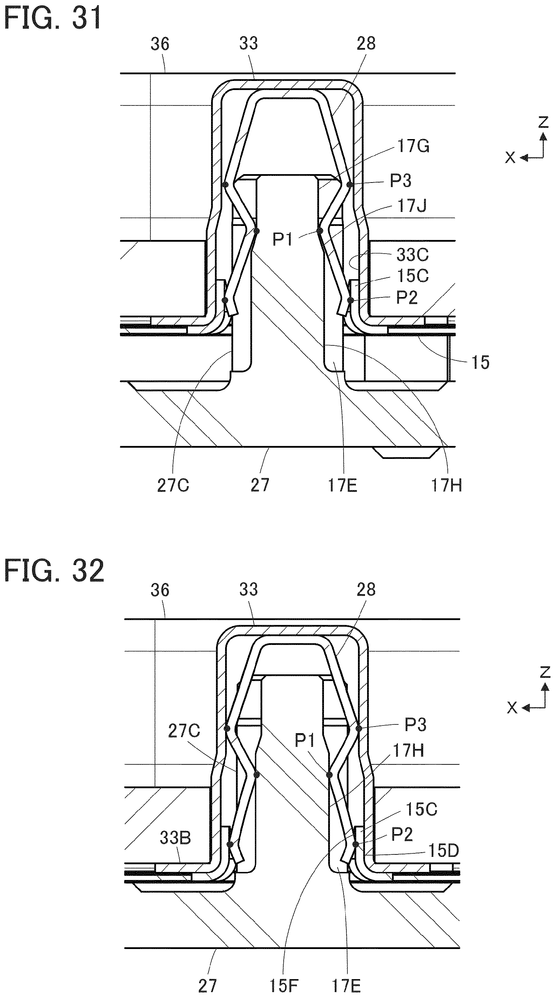

In this state, the bottom insulator 27 is pushed toward the top insulator 36 in the +Z direction with the sheet type conductive member 15 being sandwiched therebetween. As a consequence, as shown in FIG. 31, each inner contact 28 temporarily retained on the bottom insulator 27 is inserted into the recessed portion 33C of the corresponding plug contact 33 while pushing the corresponding pair of protruding portions 15C of the sheet type conductive member 15.

The pair of protruding portions 15C of the sheet type conductive member 15 pushed into the recessed portion 33C of the plug contact 33 are sandwiched between the pair of pressing portions P2 of the inner contact 28 and the inner surface of the recessed portion 33C of the plug contact 33.

It is assumed that with no external force acting on the inner contact 28, the distance between the pair of contact portions P3 in the X direction has a dimension substantially equal to or slightly smaller than a distance between the inner surfaces of the recessed portion 33C of the plug contact 33 in the X direction.

Accordingly, the pair of protruding portions 15C of the sheet type conductive member 15 are smoothly inserted into the recessed portion 33C of the plug contact 33 without being subjected to a large force from the inner contact 28 and being rubbed.

Further, when the bottom insulator 27 is pushed toward the top insulator 36, the pair of projection contacting portions P1 of the inner contact 28 are relatively moved in the -Z direction with respect to the projection 27C from the first bottom surfaces 17G of the pair of first arm insertion grooves 17E of the projection 27C to the second bottom surfaces 17H thereof through the inclined bottom surfaces 17J thereof while being elastically displaced in the X direction.

The ends of the bosses 16C of the top insulator 36 projecting on the -Z direction side of the bottom insulator 27 are thermally deformed, whereby the top insulator 36 and the bottom insulator 27 are fixed to each other. Thus, the assembling operation of the connector 31 is completed.

Also in the connector 31 thus assembled, as with the connector 21 of Embodiment 2, the pair of projection contacting portions P1 of the inner contact 28 make contact with the second bottom surfaces 17H of the pair of first arm insertion grooves 17E of the projection 27C as shown in FIG. 32, so that the distance between the pair of projection contacting portions P1 in the X direction is widened. Accordingly, elastic forces acting to widen the distance between the pair of pressing portions P2 in the X direction are exerted on the pair of pressing portions P2, and the pair of protruding portions 15C of the sheet type conductive member 15 are separately pressed against the inner surface of the recessed portion 33C of the plug contact 33.

Thus, the wiring layer 15D on the top surfaces of the protruding portions 15C makes contact with the inner surface of the recessed portion 33C of the plug contact 33 at a predetermined contact pressure, while the wiring layer 15F on the bottom surfaces of the protruding portions 15C makes contact with the pressing portions P2 of the inner contact 28 at a predetermined contact pressure.

In addition, the pair of contact portions P3 of the inner contact 28 are pressed against the inner surface of the recessed portion 33C of the plug contact 33, whereby the inner contact 28 is electrically connected to the plug contact 33.

Consequently, the wiring layer 15D exposed on the top surfaces of the protruding portions 15C of the sheet type conductive member 15 are electrically connected to the plug contact 33 directly, while the wiring layer 15F exposed on the bottom surfaces of the protruding portions 15C of the sheet type conductive member 15 are electrically connected to the plug contact 33 via the inner contact 28. In other words, both the wiring layers 15D and 15F are connected to the plug contact 33.

Thus, also in the connector 31, both the wiring layer 15D formed of a flexible conductor disposed on the top surface side of the sheet type conductive member 15 and the wiring layer 15F formed of a flexible conductor disposed on the bottom surface side of the same can be electrically connected to one plug contact 33.

Therefore, when the connector 31 is connected to a sheet type conductive member having a flexible conductor exposed only on the top surface side, the plug contact 33 can be electrically connected to the flexible conductor on the top surface side of the sheet type conductive member, and when the connector 31 is connected to a sheet type conductive member having a flexible conductor exposed only on the bottom surface side, the plug contact 33 can be electrically connected to the flexible conductor on the bottom surface side of the sheet type conductive member, as with Embodiments 1 and 2.

The pair of protruding portions 15C of the sheet type conductive member 15 are not subjected to a large force from the inner contact 28 and not rubbed when inserted into the recessed portion 33C of the plug contact 33, and hence, the flexible conductors forming the wiring layers 15D and 15F of the sheet type conductive member 15 are prevented from being broken, thus ensuring the reliability of electric connection between the flexible conductors and the plug contact 33.

In Embodiments 1 to 3 above, the plug contact 13, 33 disposed in the contact arrangement region 15A of the sheet type conductive member 15 makes contact with both the wiring layer 15D exposed on the top surface side of the sheet type conductive member 15 and the wiring layer 15F exposed on the bottom surface side of the sheet type conductive member 15; however, for instance, it is also possible to connect only the wiring layer 15D exposed on the bottom surface side of the sheet type conductive member 15 to the plug contact 13, 33 disposed in the contact arrangement region 15A.

While the sheet type conductive member 15 used in Embodiments 1 to 3 above has a multilayer structure, the invention is not limited thereto, and it is sufficient that a conductive member has a flexible conductor exposed on at least one surface of the conductive member.

While the two layers of flexible conductors, namely, the wiring layer 15D and the wiring layer 15F, of the sheet type conductive member 15 are connected to one plug contact 13, 33 in Embodiments 1 to 3 above, the invention is not limited thereto, and three or more layers of flexible conductors can be connected to one plug contact 13, 33.

While the connector 11, 21, 31 according to Embodiments 1 to 3 above has four plug contacts 13, 33, the number of the plug contacts 13, 33 is not limited, and it is sufficient that there is provided one plug contact 13, 33 electrically connected to a flexible conductor exposed on at least one surface of the sheet type conductive member 15.

## Claims

1. A connector comprising:
a plug contact (13, 33) having a conductive property and including a recessed portion (13C, 33C) extending along a fitting axis (C);
an inner contact (18, 28) having a conductive property and inserted in the recessed portion; and
a bottom insulator (17, 27) including a projection (17C, 27C) extending along the fitting axis and inserted in the recessed portion,
wherein the inner contact (18, 28) includes
a contact portion (P3) that is elastically displaceable in a direction perpendicular to the fitting axis and makes contact with the plug contact in the recessed portion,
a projection contacting portion (P1) that is elastically displaceable in a direction perpendicular to the fitting axis and makes contact with a lateral surface of the projection in the recessed portion, and
a pressing portion (P2) that is elastically displaceable in a direction perpendicular to the fitting axis and faces an inner surface of the recessed portion, and
a part of a connection object (15) of sheet type having a flexible conductor (15D, 15F) exposed on at least one surface of the connection object is sandwiched between the pressing portion and the inner surface of the recessed portion in a direction perpendicular to the fitting axis, the inner surface of the recessed portion makes contact with a top surface of the connection object, and the pressing portion makes contact with a bottom surface of the connection object, whereby the plug contact (13, 33) is electrically connected to the flexible conductor (15D) directly when the flexible conductor (15D) is exposed on the top surface of the connection object, and the plug contact (13, 33) is electrically connected to the flexible conductor (15F) via the inner contact (18, 28) when the flexible conductor (15F) is exposed on the bottom surface of the connection object.

2. The connector according to claim 1,
wherein the inner contact (18, 28) includes: a base portion (18A, 28A) facing a bottom surface of the recessed portion within the recessed portion; and a pair of first arm portions (18B, 28B) that extend in a direction along at least the fitting axis separately from opposite ends of the base portion in a first direction perpendicular to the fitting axis and face each other in the first direction, and
the projection contacting portion (P1) is disposed at each of intermediate portions of the pair of first arm portions, and the pressing portion (P2) is disposed at each of tip portions of the pair of first arm portions.

3. The connector according to claim 2,
wherein the intermediate portions of the pair of first arm portions (18B) have a pair of first bending portions (18D) each bent to project in the first direction,
each of projecting surfaces of the pair of first bending portions that face each other forms the projection contacting portion (P1), and
the pressing portions (P2) disposed at the tip portions of the pair of first arm portions face opposite directions from each other along the first direction.

4. The connector according to claim 2 or 3,
wherein the inner contact (18) includes a pair of second arm portions (18C) that extend in a direction along at least the fitting axis separately from opposite ends of the base portion in a second direction perpendicular to the fitting axis and also perpendicular to the first direction and that face each other in the second direction, and
the contact portion (P3) is disposed at each of tip portions of the pair of second arm portions.

5. The connector according to claim 4,
wherein the contact portions (P3) disposed at the tip portions of the pair of second arm portions (18C) face opposite directions from each other along the second direction.

6. The connector according to claim 2,
wherein the contact portion (P3) is disposed between a joint portion at which each of the pair of first arm portions (28B) and the base portion (28A) are joined together and an associated one of the intermediate portions.

7. The connector according to claim 6,
wherein the pair of first arm portions (28B) include a pair of second bending portions (28E) that are each situated between the joint portion at which each of the pair of first arm portions and the base portion (28A) are joined together and an associated one of the intermediate portions and that are bent to project in opposite directions from each other along the first direction, and
each of projecting surfaces of the pair of second bending portions that face opposite directions from each other forms the contact portion (P3).

8. The connector according to any one of claims 2-7,
wherein the projection (17C, 27C) includes a pair of first arm insertion grooves (17E) which extend along the fitting axis at the lateral surface of the projection on opposite sides in the first direction and in which the pair of first arm portions (18B, 28B) are inserted, and
when the projection contacting portions (P1) of the pair of first arm portions make contact with bottom surfaces of the pair of first arm insertion grooves, the pressing portions (P2) connected to the projection contacting portions are pressed against the inner surface of the recessed portion (13C, 33C).

9. The connector according to claim 4 or 5,
wherein the projection (17C) includes a pair of second arm insertion grooves (17F) which extend along the fitting axis at the lateral surface of the projection on opposite sides in the second direction and in which the pair of second arm portions are inserted.

10. The connector according to any one of claims 1-9,
wherein the plug contact (13, 33) includes: a protrusion portion (13A, 33A) protruding along the fitting axis; and a flange (13B, 33B) extending from a base end of the protrusion portion in a direction perpendicular to the fitting axis, and
the recessed portion (13C, 33C) is constituted of an interior of the protrusion portion.

11. The connector according to claim 10,
wherein the plug contact (13) includes: the protrusion portion constituted of a tubular portion (13A); and the flange (13B) in a discoid shape extending in a radial direction from an outer periphery of the base end of the tubular portion.

12. The connector according to claim 10,
wherein the plug contact (33) includes: the protrusion portion constituted of a U-shaped portion (33A); and the flange (33B) comprising a pair of flat plate flanges extending from opposite ends of the U-shaped portion in opposite directions from each other.

13. The connector according to any one of claims 10-12, comprising a housing (12, 22, 32) having an insulating property and configured to retain the connection object (15), the plug contact (13, 33), and the inner contact (18, 28),
wherein the housing includes:
a top insulator (16, 36) provided with a contact through-hole (16B, 36B) through which the protrusion portion of the plug contact is passed; and
the bottom insulator (17, 27), and
the top insulator is fixed to the bottom insulator such that the protrusion portion of the plug contact is passed through the contact through-hole and the connection object and the flange are sandwiched between the top insulator (16, 36) and the bottom insulator (17, 27).

14. A connecting method for connecting the plug contact (13, 33) to the flexible conductor (15D, 15F) of the connection object (15) by use of the connector (11, 21) according to any one of claims 1-13, the method comprising:
disposing the connection object (15) with respect to the plug contact (13, 33) such that the flexible conductor exposed on at least one surface of the connection object is positioned at an opening end portion of the recessed portion of the plug contact;
inserting the inner contact into the recessed portion while pushing the connection object into the recessed portion such that the contact portion (P3) of the inner contact (18, 28) makes contact with the plug contact within the recessed portion (13C, 33C) and that the connection object (15) is sandwiched between the pressing portion (P2) of the inner contact and the inner surface of the recessed portion in a direction perpendicular to the fitting axis (C); and
inserting the projection of the bottom insulator into the recessed portion such that the lateral surface of the projection makes contact with the projection contacting portion of the inner contact, whereupon the inner surface of the recessed portion makes contact with the top surface of the connection object, and the pressing portion makes contact with the bottom surface of the connection object, whereby the plug contact (13, 33) is electrically connected to the flexible conductor (15D) directly when the flexible conductor (15D) is exposed on the top surface of the connection object, and the plug contact (13, 33) is electrically connected to the flexible conductor (15F) via the inner contact (18, 28) when the flexible conductor (15F) is exposed on the bottom surface of the connection object.

## Patentansprüche

1. Verbinder, umfassend:
einen Steckkontakt (13, 33), der eine leitende Eigenschaft besitzt und einen ausgesparten Abschnitt (13C, 33C) aufweist, der sich entlang einer Montageachse (C) erstreckt;
einen inneren Kontakt (18, 28), der eine leitende Eigenschaft besitzt und in den ausgesparten Abschnitt eingesetzt ist; und
einen unteren Isolator (17, 27), der einen Vorsprung (17C, 27C) aufweist, der sich entlang der Montageachse erstreckt und in den ausgesparten Abschnitt eingesetzt ist,
wobei der innere Kontakt (18, 28) aufweist:
einen Kontaktabschnitt (P3), der in einer Richtung senkrecht zu der Montageachse elastisch verschiebbar ist und mit dem Steckkontakt in dem ausgesparten Abschnitt Kontakt herstellt,
einen Vorsprungkontaktierungsabschnitt (P1), der in einer Richtung senkrecht zu der Montageachse elastisch verschiebbar ist und mit einer Seitenfläche des Vorsprungs in dem ausgesparten Abschnitt Kontakt herstellt, und
einen Drückabschnitt (P2), der in einer Richtung senkrecht zu der Montageachse elastisch verschiebbar ist und einer Innenfläche des ausgesparten Abschnitts zugewandt ist, und ein Teil eines Verbindungsobjekts (15) vom Flachmaterialtyp, der einen flexiblen Leiter (15D, 15F) aufweist, der an mindestens einer Fläche des Verbindungsobjekts frei liegt, zwischen dem Drückabschnitt und einer Innenfläche des ausgesparten Abschnitts in einer Richtung senkrecht zu der Montageachse aufgenommen ist, die Innenfläche des ausgesparten Abschnitts Kontakt mit einer Oberseite des Verbindungsobjekts herstellt, und der Drückabschnitt Kontakt mit einer Unterseite des Verbindungsobjekts herstellt, wodurch der Steckkontakt (13, 33) direkt elektrisch mit dem flexiblen Leiter (15D) verbunden ist, wenn der flexible Leiter (15D) an der Oberseite des Verbindungsobjekts frei liegt, und der Steckkontakt (13, 33) über den inneren Kontakt (18, 28) elektrisch mit dem flexiblen Leiter (15F) verbunden ist, wenn der flexible Leiter (15F) an der Unterseite des Verbindungsobjekts frei liegt.

2. Verbinder nach Anspruch 1,
wobei der innere Kontakt (18, 28) aufweist: einen Basisabschnitt (18A, 28A), der einer Unterseite des ausgesparten Abschnitts innerhalb des ausgesparten Abschnitts zugewandt ist; und ein Paar von ersten Armabschnitten (18B, 28B), die sich in einer Richtung entlang mindestens der Montageachse getrennt von gegenüberliegenden Enden des Basisabschnitts in einer ersten Richtung senkrecht zu der Montageachse erstrecken und einander in der ersten Richtung zugewandt sind, und
der Vorsprungkontaktierungsabschnitt (P1) an jedem von Zwischenabschnitten des Paares von ersten Armabschnitten angeordnet ist und der Drückabschnitt (P2) an jedem von Spitzenabschnitten des Paares von ersten Armabschnitten angeordnet ist.

3. Verbinder nach Anspruch 2,
wobei die Zwischenabschnitte des Paares von ersten Armabschnitten (18B) ein Paar von ersten Biegeabschnitten (18D) aufweisen, die jeweils so gebogen sind, dass sie in der ersten Richtung vorstehen,
jede der vorstehenden Flächen des Paares von ersten Biegeabschnitten, die einander zugewandt sind, den Vorsprungkontaktierungsabschnitt (P1) bildet, und
die Drückabschnitte (P2), die an den Spitzenabschnitten des Paares von ersten Armabschnitten angeordnet sind, entlang der ersten Richtung in voneinander entgegengesetzte Richtungen weisen.

4. Verbinder nach Anspruch 2 oder 3,
wobei der innere Kontakt (18) ein Paar von zweiten Armabschnitten (18C) aufweist, die sich in einer Richtung entlang mindestens der Montageachse getrennt von gegenüberliegenden Enden des Basisabschnitts in einer zweiten Richtung senkrecht zu der Montageachse und außerdem senkrecht zu der ersten Richtung erstrecken und die einander in der zweiten Richtung zugewandt sind, und der Kontaktabschnitt (P3) an jedem von Spitzenabschnitten des Paares von zweiten Armabschnitten angeordnet ist.

5. Verbinder nach Anspruch 4,
wobei die Kontaktabschnitte (P3), die an den Spitzenabschnitten des Paares von zweiten Armabschnitten (18C) angeordnet sind, entlang der zweiten Richtung in voneinander entgegengesetzte Richtungen weisen.

6. Verbinder nach Anspruch 2,
wobei der Kontaktabschnitt (P3) zwischen einem Verbindungsabschnitt, an dem jeder des Paares von ersten Armabschnitten (28B) und der Basisabschnitt (28A) miteinander verbunden sind, und einem zugehörigen der Zwischenabschnitte angeordnet ist.

7. Verbinder nach Anspruch 6,
wobei das Paar von ersten Armabschnitten (28B) ein Paar von zweiten Biegeabschnitten (28E) umfasst, die sich jeweils zwischen dem Verbindungsabschnitt, an dem jeder des Paares von ersten Armabschnitten und der Basisabschnitt (28A) miteinander verbunden sind, und einem zugehörigen der Zwischenabschnitte befinden und die so gebogen sind, dass sie entlang der ersten Richtung in voneinander entgegengesetzte Richtungen vorstehen, und
jede der vorstehenden Flächen des Paares von zweiten Biegeabschnitten, die in voneinander entgegengesetzte Richtungen weisen, den Kontaktabschnitt (P3) bildet.

8. Verbinder nach einem der Ansprüche 2-7,
wobei der Vorsprung (17C, 27C) ein Paar von ersten Armeinführnuten (17E) aufweist, die sich entlang der Montageachse an der Seitenfläche des Vorsprungs an gegenüberliegenden Seiten in der ersten Richtung erstrecken und in die das Paar von ersten Armabschnitten (18B, 28B) eingeführt ist, und
wenn die Vorsprungkontaktierungsabschnitte (P1) des Paares von ersten Armabschnitten Kontakt mit Unterseiten des Paares von ersten Armeinführnuten herstellen, die mit den Vorsprungkontaktierungsabschnitten verbundenen Drückabschnitte (P2) gegen die Innenfläche des ausgesparten Abschnitts (13C, 33C) gedrückt werden.

9. Verbinder nach Anspruch 4 oder 5,
wobei der Vorsprung (17C) ein Paar von zweiten Armeinführnuten (17F) aufweist, die sich entlang der Montageachse an der Seitenfläche des Vorsprungs auf gegenüberliegenden Seiten in der zweiten Richtung erstrecken und in die das Paar von zweiten Armabschnitten eingeführt ist.

10. Verbinder nach einem der Ansprüche 1-9,
wobei der Steckkontakt (13, 33) aufweist: einen Vorsprungsabschnitt (13A, 33A), der entlang der Montageachse vorsteht; und einen Flansch (13B, 33B), der sich von einem Basisende des Vorsprungsabschnitts in einer Richtung senkrecht zu der Montageachse erstreckt, und
der ausgesparte Abschnitt (13C, 33C) von einem Inneren des Vorsprungsabschnitts gebildet ist.

11. Verbinder nach Anspruch 10,
wobei der Steckkontakt (13) aufweist: den Vorsprungsabschnitt, der von einem rohrförmigen Abschnitt (13A) gebildet ist; und den Flansch (13B) in einer Scheibenform, der sich in einer radialen Richtung von einem Außenumfang des Basisendes des rohrförmigen Abschnitts erstreckt.

12. Verbinder nach Anspruch 10,
wobei der Steckkontakt (33) aufweist: den Vorsprungsabschnitt, der von einem U-förmigen Abschnitt (33A) gebildet ist; und den Flansch (33B), der ein Paar von flachen Plattenflansche umfasst, die sich von entgegengesetzten Enden des U-förmigen Abschnitts in voneinander entgegengesetzte Richtungen erstrecken.

13. Verbinder nach einem der Ansprüche 10-12, der ein Gehäuse (12, 22, 32) umfasst, das eine isolierende Eigenschaft besitzt und dazu eingerichtet ist, das Verbindungsobjekt (15), den Steckkontakt (13, 33) und den inneren Kontakt (18, 28) zu halten,
wobei das Gehäuse aufweist:
einen oberen Isolator (16, 36), mit einem Kontaktdurchgangsloch (16B, 36B) versehen ist, durch das der Vorsprungsabschnitt des Steckkontakts hindurchgeführt ist; und den unteren Isolator (17, 27), und
der obere Isolator so an dem unteren Isolator befestigt ist, dass der Vorsprungsabschnitt des Steckkontakts durch das Kontaktdurchgangsloch hindurch führt und das Verbindungsobjekt und der Flansch zwischen dem oberen Isolator (16, 36) und dem unteren Isolator (17, 27) sandwichartig aufgenommen ist.

14. Verbindungsverfahren zum Verbinden des Steckkontakts (13, 33) mit dem flexiblen Leiter (15D, 15F) des Verbindungsobjekts (15) unter Verwendung des Verbinders (11, 21) nach einem der Ansprüche 1-13, wobei das Verfahren umfasst:
Anordnen des Verbindungsobjekts (15) in Bezug auf den Steckkontakt (13, 33) so, dass der flexible Leiter, der an mindestens einer Fläche des Verbindungsobjekts frei liegt, an einem Öffnungsendabschnitt des ausgesparten Abschnitts des Steckkontakts positioniert ist;
Einführen des inneren Kontakts in den ausgesparten Abschnitt, während das Verbindungsobjekt in den ausgesparten Abschnitt geschoben wird, dergestalt, dass der Kontaktabschnitt (P3) des inneren Kontakts (18, 28) Kontakt mit dem Steckkontakt innerhalb des ausgesparten Abschnitts (13C, 33C) herstellt und dass das Verbindungsobjekt (15) zwischen dem Drückabschnitt (P2) des inneren Kontakts und der Innenfläche des ausgesparten Abschnitts in einer Richtung senkrecht zu der Montageachse (C) aufgenommen ist; und
Einführen des Vorsprungs des unteren Isolators in den ausgesparten Abschnitt so, dass die Seitenfläche des Vorsprungs Kontakt mit dem Vorsprungkontaktierungsabschnitt des inneren Kontakts herstellt, woraufhin die Innenfläche des ausgesparten Abschnitts Kontakt mit der Oberseite des Verbindungsobjekts herstellt und der Drückabschnitt Kontakt mit der Unterseite des Verbindungsobjekts herstellt, wodurch der Steckkontakt (13, 33) direkt mit dem flexiblen Leiter (15D) elektrisch verbunden ist, wenn der flexible Leiter (15D) an der Oberseite des Verbindungsobjekts frei liegt, und der Steckkontakt (13, 33) über den inneren Kontakt (18, 28) elektrisch mit dem flexiblen Leiter (15F) verbunden ist, wenn der flexible Leiter (15F) an der Unterseite des Verbindungsobjekts frei liegt.

## Revendications

1. Connecteur comprenant :
un contact à fiche (13, 33) ayant une propriété conductrice et incluant une partie évidée (13C, 33C) s'étendant le long d'un axe d'ajustage (C) ;
un contact interne (18, 28) ayant une propriété conductrice et inséré dans la partie évidée ; et
un isolant inférieur (17, 27) comportant une protubérance (17C, 27C) s'étendant le long de l'axe d'ajustage et inséré dans la partie évidée,
dans lequel le contact interne (18, 28) comporte
une partie de contact (P3) qui est déplaçable élastiquement dans une direction perpendiculaire à l'axe d'ajustage et qui entre en contact avec le contact à fiche dans la partie évidée,
une partie de contact avec la protubérance (P1) qui est déplaçable élastiquement dans une direction perpendiculaire à l'axe d'ajustage et qui entre en contact avec une surface latérale de la protubérance dans la partie évidée, et
une partie de pression (P2) qui est déplaçable élastiquement dans une direction perpendiculaire à l'axe d'ajustage et qui fait face à une surface interne de la partie évidée, et
une partie d'un objet de connexion (15) de type feuille comportant un conducteur flexible (15D, 15F) exposé sur au moins une surface de l'objet de connexion est prise en sandwich entre la partie de pression et la surface interne de la partie évidée dans une direction perpendiculaire à l'axe d'ajustage, la surface interne de la partie évidée est en contact avec une surface supérieure de l'objet de connexion, et la partie de pression est en contact avec une surface inférieure de l'objet de connexion, moyennant quoi le contact à fiche (13, 33) est relié électriquement au conducteur flexible (15D) directement lorsque le conducteur flexible (15D) est exposé sur la surface supérieure de l'objet de connexion, et le contact à fiche (13, 33) est relié électriquement au conducteur flexible (15F) par l'intermédiaire du contact interne (18, 28) lorsque le conducteur flexible (15F) est exposé sur la surface inférieure de l'objet de connexion.

2. Connecteur selon la revendication 1,
dans lequel le contact interne (18, 28) comporte : une partie de base (18A, 28A) faisant face à une surface inférieure de la partie évidée à l'intérieur de la partie évidée ; et une paire de premières parties de bras (18B, 28B) qui s'étendent dans une direction le long d'au moins l'axe d'ajustage séparément à partir d'extrémités opposées de la partie de base dans une première direction perpendiculaire à l'axe d'ajustage et qui se font face l'une à l'autre dans la première direction, et
la partie de contact avec la protubérance (P1) est disposée au niveau de chacune de parties intermédiaires de la paire de premières parties de bras, et la partie de pression (P2) est disposée au niveau de chacune de parties de pointe de la paire de premières parties de bras.

3. Connecteur selon la revendication 2,
dans lequel les parties intermédiaires de la paire de premières parties de bras (18B) ont une paire de premières parties de flexion (18D) chacune pliée pour faire saillie dans la première direction,
chacune de surfaces en saillie de la paire de premières parties de flexion qui se font face forme la partie de contact avec la protubérance (P1), et
les parties de pression (P2) disposées au niveau des parties de pointe de la paire de premières parties de bras sont orientées dans des directions opposées l'une par rapport à l'autre le long de la première direction.

4. Connecteur selon la revendication 2 ou 3,
dans lequel le contact interne (18) comporte une paire de secondes parties de bras (18C) qui s'étendent dans une direction le long d'au moins l'axe d'ajustage séparément à partir d'extrémités opposées de la partie de base dans une seconde direction perpendiculaire à l'axe d'ajustage et également perpendiculaire à la première direction et qui se font face l'une à l'autre dans la seconde direction, et la partie de contact (P3) est disposée au niveau de chacune de parties de pointe de la paire de secondes parties de bras.

5. Connecteur selon la revendication 4,
dans lequel les parties de contact (P3) disposées au niveau des parties de pointe de la paire de secondes parties de bras (18C) sont orientées dans des directions opposées l'une à l'autre le long de la seconde direction.

6. Connecteur selon la revendication 2,
dans lequel la partie de contact (P3) est disposée entre une partie de jonction au niveau de laquelle chacune de la paire de premières parties de bras (28B) et la partie de base (28A) sont jointes ensemble et une partie intermédiaire associée parmi les parties intermédiaires .

7. Connecteur selon la revendication 6,
dans lequel la paire de premières parties de bras (28B) comporte une paire de secondes parties de flexion (28E) qui sont chacune situées entre la partie de jonction au niveau de laquelle chacune de la paire de premières parties de bras et la partie de base (28A) sont jointes ensemble et une partie intermédiaires associée parmi les parties intermédiaires et qui sont pliées pour faire saillie dans des directions opposées l'une à l'autre le long de la première direction, et
chacune de surfaces en saillie de la paire de secondes parties de flexion qui sont orientées dans des directions opposées l'une à l'autre forme la partie de contact (P3).

8. Connecteur selon l'une quelconque des revendications 2 à 7,
dans lequel la protubérance (17C, 27C) comporte une paire de premières rainures d'insertion de bras (17E) qui s'étendent le long de l'axe d'ajustage au niveau de la surface latérale de la protubérance sur des côtés opposés dans la première direction et dans lesquelles la paire de premières parties de bras (18B, 28B) est insérée, et
lorsque les parties de contact avec la protubérance (P1) de la paire de premières parties de bras entrent en contact avec des surfaces inférieures de la paire de premières rainures d'insertion de bras, les parties de pression (P2) reliées aux parties de contact avec la protubérance sont pressées contre la surface interne de la partie évidée (13C, 33C).

9. Connecteur selon la revendication 4 ou 5,
dans lequel la protubérance (17C) comporte une paire de secondes rainures d'insertion de bras (17F) qui s'étendent le long de l'axe d'ajustage au niveau de la surface latérale de la protubérance sur des côtés opposés dans la seconde direction et dans lesquelles la paire de secondes parties de bras est insérée.

10. Connecteur selon l'une quelconque des revendications 1 à 9,
dans lequel le contact à fiche (13, 33) comporte : une partie protubérante (13A, 33A) faisant saillie le long de l'axe d'ajustage ; et une bride (13B, 33B) s'étendant à partir d'une extrémité de base de la partie protubérante dans une direction perpendiculaire à l'axe d'ajustage, et
la partie évidée (13C, 33C) est constituée d'un intérieur de la partie protubérante.

11. Connecteur selon la revendication 10,
dans lequel le contact à fiche (13) comporte : la partie protubérante constituée d'une partie tubulaire (13A) ; et
la bride (13B) en forme de disque s'étendant dans une direction radiale à partir d'une périphérie extérieure de l'extrémité de base de la partie tubulaire.

12. Connecteur selon la revendication 10,
dans lequel le contact à fiche (33) comporte : la partie protubérante constituée d'une partie en forme de U (33A) ;
et la bride (33B) comprenant une paire de brides plates s'étendant à partir d'extrémités opposées de la partie en forme de U dans des directions opposées l'une à l'autre.

13. Connecteur selon l'une quelconque des revendications 10 à 12, comprenant un boîtier (12, 22, 32) ayant une propriété isolante et configuré pour retenir l'objet de connexion (15), le contact à fiche (13, 33), et le contact interne (18, 28),
dans lequel le boîtier comporte :
un isolant supérieur (16, 36) pourvu d'un trou de passage de contact (16B, 36B) à travers lequel passe la partie protubérante du contact à fiche ; et
l'isolant inférieur (17, 27), et
l'isolant supérieur est fixé à l'isolant inférieur de telle sorte que la partie protubérante du contact à fiche passe à travers le trou de passage de contact et que l'objet de connexion et la bride soient pris en sandwich entre l'isolant supérieur (16, 36) et l'isolant inférieur (17, 27).

14. Procédé de connexion pour connecter le contact à fiche (13, 33) au conducteur flexible (15D, 15F) de l'objet de connexion (15) à l'aide du connecteur (11, 21) selon l'une quelconque des revendications 1 à 13, le procédé comprenant :
la disposition de l'objet de connexion (15) par rapport au contact à fiche (13, 33) de telle sorte que le conducteur flexible exposé sur au moins une surface de l'objet de connexion soit positionné au niveau d'une partie d'extrémité d'ouverture de la partie évidée du contact à fiche ;
l'insertion du contact interne dans la partie évidée tout en poussant l'objet de connexion dans la partie évidée de sorte que la partie de contact (P3) du contact interne (18, 28) entre en contact avec le contact à fiche dans la partie évidée (13C, 33C) et que l'objet de connexion (15) soit pris en sandwich entre la partie de pression (P2) du contact interne et la surface interne de la partie évidée dans une direction perpendiculaire à l'axe d'ajustage (C) ; et
l'insertion de la protubérance de l'isolant inférieur dans la partie évidée de telle sorte que la surface latérale de la protubérance entre en contact avec la partie de contact avec la protubérance du contact interne, après quoi la surface interne de la partie évidée entre en contact avec la surface supérieure de l'objet de connexion, et la partie de pression entre en contact avec la surface inférieure de l'objet de connexion, moyennant quoi le contact à fiche (13, 33) est relié électriquement au conducteur flexible (15D) directement lorsque le conducteur flexible (15D) est exposé sur la surface supérieure de l'objet de connexion, et le contact à fiche (13, 33) est relié électriquement au conducteur flexible (15F) par l'intermédiaire du contact interne (18, 28) lorsque le conducteur flexible (15F) est exposé sur la surface inférieure de l'objet de connexion.
